(19)

Europäisches
Patentamt

European
Patent Office

Office européen
des brevets

(11) **EP 4 388 333 B1**

(12) **EUROPÄISCHE PATENTSCHRIFT**

(45) Veröffentlichungstag und Bekanntmachung des
Hinweises auf die Patenterteilung:
**15.07.2026 Patentblatt 2026/29**

(21) Anmeldenummer: **22765119.7**

(22) Anmeldetag: **16.08.2022**

(51) Internationale Patentklassifikation (IPC):
**G01R 31/62** *(2020.01)* **G01R 31/72** *(2020.01)*

(52) Gemeinsame Patentklassifikation (CPC):
**G01R 31/62; G01R 31/72**

(86) Internationale Anmeldenummer:
**PCT/EP2022/072866**

(87) Internationale Veröffentlichungsnummer:
**WO 2023/021037 (23.02.2023 Gazette 2023/08)**

(54) **VERFAHREN UND VORRICHTUNG ZUM PRÜFEN EINES SPANNUNGSWANDLERS**

METHOD AND DEVICE FOR TESTING A VOLTAGE CONVERTER

PROCÉDÉ ET DISPOSITIF POUR CONTRÔLER UN CONVERTISSEUR DE TENSION

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorität: **20.08.2021 AT 506762021**

(43) Veröffentlichungstag der Anmeldung:
**26.06.2024 Patentblatt 2024/26**

(73) Patentinhaber: **Omicron electronics GmbH
6833 Klaus (AT)**

(72) Erfinder: **GOPP, David
6850 Dornbirn (AT)**

(74) Vertreter: **Kraus & Lederer PartGmbB
Thomas-Wimmer-Ring 15
80539 München (DE)**

(56) Entgegenhaltungen:
**DE-A1- 102018 200 869 US-A1- 2015 288 277**

• **GOPP DAVID: "Einflussgrößen bei
der modellbasierten Prüfung von
kapazitiven Spannungswandlern - Was sind die
einflussreichsten Parameter der modellbasierten
Prüfung von kapazitiven
Spannungswandlern und wie wirken sich diese
auf den Übersetzungs-und Phasenfehler
aus?", MASTERARBEIT FACHHOCHSCHULE
VORARLBERG, 1 August 2019 (2019-08-01),
pages 1 - 104, XP055828668, Retrieved from the
Internet <URL:https://opus.fhv.at/frontdoor/
deliver/index/docId/3147/file/Masterarbeit_Gopp.
pdf> [retrieved on 20210729], DOI: 10.25924/
opus-3147**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

GEBIET DER ERFINDUNG

Die vorliegende Erfindung betrifft eine Vorrichtung zum Prüfen eines Spannungswandlers, beispielsweise eines induktiven Spannungswandlers oder eines Niedrigstrom-Spannungswandlers (englisch: Low Power Voltage Transformer, LPVT), sowie ein entsprechendes Verfahren zum Prüfen eines Spannungswandlers.

HINTERGRUND

Durch die Änderung der Topologie von stromtechnischen Verteilungs- und Übertragungsnetzen in Richtung Dezentralisierung bei der Stromerzeugung steigt die Menge der elektronischen Komponenten deutlich an. Die sogenannte "grüne" Energie (aus Windparks, Solarparks und anderen alternativen Energiequellen) nimmt deutlich zu. Häufig wird die so erzeugte elektrische Energie mit Hilfe von Halbleitertechnologien in die Verteilungs- und Übertragungsnetze eingespeist. Energie aus diesen Quellen ist häufig abhängig von den Umweltveränderungen und daher hat jede Tageszeit- oder Wetteränderung einen direkten Einfluss auf eine Anzahl von Schaltvorgängen, die zur Kontrolle der Netzstabilität notwendig sind. Darüber hinaus hat die zunehmende Anzahl von Lasten, die auf elektronisch gesteuerten Technologien basieren, wie zum Beispiel Leistungselektronik oder frequenzvariable Antriebe, Auswirkungen auf das Netz. Durch die genannten Einflüsse können vermehrt transiente Spannungsimpulse, Oberschwingungen, Unterschwingungen oder Offsetspannungen mit Spannungen von Gleichstrom bis zu mehreren kHz auftreten. Solche Phänomene können nur mit Hochspannungsmessungen, die eine entsprechend hohe Genauigkeit aufweisen, insbesondere im Bereich von Gleichstrom bis zu einer Frequenz von mehreren kHz, erfasst bzw. überwacht werden.

Dazu können im Bereich der elektrischen Energietechnik Spannungswandler als Messwandler zum Messen von Wechselspannungen verwendet werden. Die Funktion eines Spannungswandlers besteht darin, eine zu messende hohe Spannung auf geringere Spannungswerte proportional zu übertragen. Diese geringere Spannung, beispielsweise Werte um 100 V, wird an Spannungsmessgeräte, Energiezähler und ähnliche Geräte übermittelt, beispielsweise für Messzwecke oder Schutzzwecke. Ein Spannungswandler kann als induktiver (sogenannter konventioneller) Spannungswandler oder als Niedrigstrom-Spannungswandler (sogenannter LPVT, Low Power Voltage Transformer, oder LPIT, Low Power Instrument Transformer) realisiert werden.

LPVTs können verschieden ausgeprägt sein. Neben einem ohmschen Spannungsteiler und einem kapazitiven Spannungsteiler (nicht-gedämpft und gedämpft) sind auch ohmsch-kapazitive Spannungsteiler in den verschiedensten Varianten im Feld zu finden. Ohmsch-kapazitive Spannungswandler werden aus zwei parallel geschalteten Spannungsteilern gebildet, wobei einer davon ein kapazitiver Spannungsteiler und ein anderer ein ohmscher Spannungsteiler ist. Sowohl der kapazitive Spannungsteiler als auch der ohmsche Spannungsteiler bestehen üblicherweise aus mindestens zwei in Reihe geschalteten Elementen. Die Parallelschaltung dieser zwei Spannungsteiler wird auch als RC-Teiler bezeichnet. Ein Ende des RC-Teilers ist mit der zu messenden Hochspannung verbunden und das andere Ende mit Erde. An einem Abgriff zwischen dem RC-Teiler liegt eine der zu messenden Hochspannung proportionale niedrigere Spannung an, welche einem Spannungsmessgerät zugeführt werden kann. Fehler im ohmsch-kapazitiven Spannungswandler können durch Defekte im ohmsch-kapazitiven Spannungsteiler verursacht werden. Es gibt verschiedene Gründe für Defekte in den Kondensatoren des kapazitiven Spannungsteilers, beispielsweise das Eindringen von Feuchtigkeit in die Isolierung.

Induktive Spannungswandler sind grundsätzlich wie Transformatoren aufgebaut. Sie bestehen aus einer Primärwicklung, welche mit der zu messenden Hochspannung elektrisch verbunden ist, und einer Sekundärwicklung, welche galvanisch getrennt ist, aus Sicherheitsgründen jedoch im Allgemeinen einseitig geerdet zu den angeschlossenen Geräten führt. Fehler im induktiven Spannungswandler können beispielsweise durch Defekte an den Wicklungsisolierungen, durch Verlagerung von Windungen der Wicklungen oder durch Defekte an einem Eisenkern, welcher die Primärwicklung und die Sekundärwicklung magnetisch gekoppelt, auftreten.

Weltweit werden hauptsächlich konventionelle Spannungswandlertechnologien eingesetzt, jedoch nimmt die Anzahl der LPVTs deutlich zu, da die Eignung hinsichtlich der Netzqualitätsmessung höher ist.

Spannungswandler (sowohl konventionelle Spannungswandler als auch LPVTs) haben aufgrund ihres inneren Aufbaus ein ausgeprägtes frequenzabhängiges Übertragungsverhalten. Anwendungen zur Erfassung der oben genannten Phänomene und somit zur Überwachung der Netzqualität erfordern Informationen über dieses frequenzabhängige Übertragungsverhalten. Entsprechende Messverfahren und Bewertungsmethoden zur Bestimmung und Beurteilung der Übertragungseigenschaften und somit zur Eignung von LPVTs und konventionellen Spannungswandlern für die Netzqualitätsmessung sind definiert. Da sehr umfangreiche elektrische Einrichtungen für diese Messverfahren benötigt werden, werden diese Messverfahren im Wesentlichen beim Hersteller durchgeführt oder mit entsprechend großem Aufwand vor Ort. In der Regel wird ein Referenzaufbau gewählt, der Frequenzen bis zu 9 kHz messen kann. Für die Bestimmung des Frequenzverhaltens von konventionellen Spannungswandlern wird eine sogenannte Zweifrequenzmethode verwendet, die eine Vorlinearisierung des Kerns durch eine 50-Hz-Grundschwingung erreicht. Auf diese Grundschwingung werden die Hochfrequenzanteile moduliert.

D. Gopp, "Einflussgrößen bei der modellbasierten Prüfung von kapazitiven Spannungswandlern - Was sind die einflussreichsten Parameter der modellbasierten Prüfung von kapazitiven Spannungswandlern und wie wirken sich diese auf den Übersetzungs- und Phasenfehler aus?", Masterarbeit Fachhochschule Vorarlberg, 1. August 2019, offenbart eine Vorrichtung gemäß dem Oberbegriff des Anspruchs 1.

Die DE 10 2018 200869 A1 offenbart ein Verfahren und eine Vorrichtung zum Überprüfen eines induktiven Ladesystems. Die US 2015/288277 A1 offenbart ein Verfahren zum Testen der Frequenzantwort eines Schaltwandlers.

## ZUSAMMENFASSUNG DER ERFINDUNG

Es besteht ein Bedarf an verbesserten Möglichkeiten zum Prüfen von Spannungswandlern, sowohl konventionellen Spannungswandlern als auch LPVTs, insbesondere mit Verfahren und Vorrichtungen, welche einfach vor Ort angewendet werden können.

Gemäß der vorliegenden Erfindung werden eine Vorrichtung zum Prüfen eines Spannungswandlers und ein Verfahren zum Prüfen eines Spannungswandlers bereitgestellt, wie sie in den unabhängigen Ansprüchen definiert sind. Die abhängigen Ansprüche definieren Ausführungsformen der Erfindung.

Eine erfindungsgemäße Vorrichtung zum Prüfen eines Spannungswandlers umfasst einen Frequenzgang-Analysator und einen Impedanzwandler. Der Frequenzgang-Analysator ist ausgestaltet, eine elektrische Übertragungsfunktion über einen vorgegebenen Frequenzbereich zu messen. Der Frequenzgang-Analysator weist einen Prüfsignalausgang, einen Referenzsignaleingang und einen Antwortsignaleingang auf.

An dem Prüfsignalausgang kann der Frequenzgang-Analysator ein Prüfsignal für den zu prüfenden Spannungswandler ausgeben. Das Prüfsignal kann beispielsweise ein Spannungssignal mit einer vorgegebenen Spannung und veränderlicher Frequenz umfassen. Die Frequenz kann beispielsweise in einem Bereich von 1 Hz bis 30 MHz variiert werden, insbesondere in einem Bereich von 20 Hz bis 2 MHz. Die Spannung kann beispielsweise in einem Bereich von einigen Volt liegen, beispielsweise im Bereich von 5-300 V. Die Spannung kann beispielsweise 10 V betragen. Die Spannung kann beispielsweise eine Wechselspannung umfassen, beispielsweise mit einer Spannung von 10 $V_{PP}$. Der Prüfsignalausgang kann einen Anschluss für ein Koaxialkabel umfassen, wobei das Prüfsignal auf den Innenleiter des Koaxialkabels ausgegeben wird und der Außenleiter des Koaxialkabels mit Masse gekoppelt wird. An dem zu testenden Spannungswandler wird der Innenleiter mit einem Anschluss des Spannungswandlers, beispielsweise an der Primärseite des Spannungswandlers, angeschlossen und der Außenleiter mit Masse des Spannungswandlers gekoppelt. Dadurch kann eine Einstrahlung von Störsignalen aus der Umgebung auf das Prüfsignal verringert oder verhindert werden.

Über den Referenzsignaleingang kann der Frequenzgang-Analysator ein Referenzsignal empfangen. Beispielsweise kann der Referenzsignaleingang mit dem gleichen Anschluss des Spannungswandlers gekoppelt werden, an dem das Prüfsignal eingespeist wird. Der Referenzsignaleingang kann einen Anschluss für ein Koaxialkabel umfassen, wobei das Referenzsignal über den Innenleiter des Koaxialkabels empfangen wird und der Außenleiter mit Masse gekoppelt wird. An dem Spannungswandler wird der Innenleiter mit dem gleichen Anschluss gekoppelt, an dem auch das Prüfsignal eingespeist wird, und der Außenleiter wird mit der Masse des Spannungswandlers gekoppelt. Über den Referenzsignaleingang kann das in den Spannungswandler eingespeiste Prüfsignal genau bestimmt werden und als Referenzsignal verwendet werden. Auf der Grundlage dieses Referenzsignals kann die Übertragungsfunktion des Spannungswandlers genau bestimmt werden.

An dem Antwortsignaleingang kann der Frequenzgang-Analysator ein Antwortsignal empfangen, welches als Antwort auf das ausgegebene Prüfsignal von dem zu prüfenden Spannungswandler erzeugt wird. Der Antwortsignaleingang hat eine vorgegebene Eingangsimpedanz, beispielsweise 50 Ohm.

Der Frequenzgang-Analysator kann beispielsweise eine Vorrichtung sein, wie sie zum Überprüfen von Leistungstransformatoren mittels einer Frequenzganganalyse (SFRA, engl.: Sweep Frequency Response Analysis) verwendet wird. Ein derartiger Frequenzgang-Analysator kann so ausgestaltet sein, dass er von einer Bedienperson transportiert werden kann, beispielsweise als tragbare Vorrichtung in einem Koffer.

Der Impedanzwandler weist einen Impedanzwandlereingang und einen Impedanzwandlerausgang auf. Der Impedanzwandlereingang hat eine einstellbare Eingangsimpedanz. Der Impedanzwandlerausgang ist mit dem Antwortsignaleingang des Frequenzgang-Analysators gekoppelt und weist eine an die Eingangsimpedanz des Antwortsignaleingangs angepasste Ausgangsimpedanz auf. Der Impedanzwandlereingang kann beispielsweise mit einem weiteren Anschluss des Spannungswandlers gekoppelt werden, beispielsweise einem Anschluss einer Sekundärseite des Spannungswandlers. Der Impedanzwandlereingang kann einen Anschluss für ein Koaxialkabel umfassen, wobei der Anschluss der Sekundärseite des Spannungswandlers mit dem Innenleiter des Koaxialkabels gekoppelt wird und der Außenleiter des Koaxialkabels sowohl an dem Spannungswandler als auch an dem Impedanzwandler mit Masse gekoppelt wird. Der Impedanzwandler empfängt somit ein Ausgangssignal von dem Spannungswandler, welches dieser als Antwort auf das Prüfsignal ausgibt, und leitet dieses Ausgangssignal als Antwortsignal an den Antwortsignaleingang des Frequenzgang-Analysators weiter, wobei die Impedanz entsprechend angepasst wird.

Zusammengefasst basiert die Vorrichtung auf dem Ansatz der SFRA-Methode und verwendet beispielsweise ein SFRA-Messgerät als Frequenzgang-Analysator. Sowohl konventionelle als auch LPVT Spannungswandler können Prinzip bedingt beliebige Impedanzen aufweisen, welche im Allgemeinen nicht der Eingangsimpedanz des Antwortsignaleingangs des SFRA-Messgeräts entsprechen. Beispielsweise kann der Antwortsignaleingang des SFRA-Messgeräts, d.h. des Frequenzgang-Analysators, eine vorgegebene Eingangsimpedanz von 50 Ohm haben, wohingegen konventionelle Spannungswandler eine Impedanz im Bereich bis zu einigen 100 Ohm aufweisen können und LPVTs sogar eine Impedanz bis zu einigen Megaohm aufweisen können. Eine Ausgangsimpedanz an dem Prüfsignalausgang des Frequenzgang-Analysators kann 50 Ohm betragen und eine Eingangsimpedanz des Referenzsignaleingangs des Frequenzgang-Analysators kann 50 Ohm betragen. Der Antwortsignaleingang ist jedoch der kritische Pfad bei einer Bestimmung einer frequenzabhängigen Übertragungseigenschaften von konventionellen Spannungswandlern und LPVTs. Das bedeutet, dass eine Abweichung der Impedanz auf der Sekundärseite des Spannungswandlers von der Eingangsimpedanz des SFRA-Messgeräts zu ungenauen Bestimmungen der frequenzabhängigen Übertragungseigenschaften des Spannungswandlers führt. Um dies zu vermeiden, wird der Impedanzwandler zwischen den Spannungswandler und den Antwortsignaleingang geschaltet. Die Ausgangsimpedanz des Impedanzwandlerausgangs ist an die Eingangsimpedanz des Antwortsignaleingangs angepasst. Eingangsimpedanz des Impedanzwandlereingangs kann auf die Ausgangsimpedanz des Spannungswandlers eingestellt werden. Die Eingangsimpedanz des Impedanzwandlereingangs kann beispielsweise in einem Bereich von 30 Ohm bis 100 Megaohm, vorzugsweise in einem Bereich von 50 Ohm bis 100 Megaohm einstellbar sein. Die Ausgangsimpedanz des Impedanzwandlers stimmt mit der Eingangsimpedanz des Antwortsignaleingangs überein, sodass auf beiden Seiten des Impedanzwandlers eine Impedanzanpassung vorliegt. So kann das frequenzabhängige Übertragungsverhalten des Spannungswandlers unter optimalen Bedingungen (z.B. bei Nennbürde des Spannungswandlers) gemessen werden.

Gemäß einer Ausführungsform kann die Vorrichtung, welche den Frequenzgang-Analysator und den Impedanzwandler umfasst, als eine mobile tragbare Vorrichtung ausgestaltet sein. Mobil und tragbar bedeutet in diesem Zusammenhang, dass die Vorrichtung von einer einzelnen Person getragen werden kann und beispielsweise in einem Koffer oder einer Tasche untergebracht werden kann. Die Vorrichtung kann beispielsweise ein Gewicht von wenigen Kilogramm, beispielsweise im Bereich von einem bis 10 kg haben.

Gemäß einer Ausführungsform umfasst die Vorrichtung mindestens eine Batterie, welche ausgestaltet ist, elektrische Energie zum Betrieb des Frequenzgang-Analysators und/oder des Impedanzwandlers bereitzustellen. Beispielsweise kann eine wiederaufladbare Batterie für den Frequenzgang-Analysator vorgesehen sein und eine weitere wiederaufladbare Batterie für den Impedanzwandler. Es kann auch eine gemeinsame (wiederaufladbare) Batterie zur Versorgung des Frequenzgang-Analysators und des Impedanzwandlers vorgesehen sein. Die Batterie kann beispielsweise zusammen mit dem Frequenzgang-Analysator und dem Impedanzwandler in dem oben genannten Koffer oder der oben genannten Tasche untergebracht sein, sodass die gesamte Vorrichtung einschließlich Batterie und gegebenenfalls entsprechenden Anschlussleitungen mobil und tragbar ist. Dadurch kann die Vorrichtung zum Überprüfen von Spannungswandlern an einer Vielzahl von Orten, welche sich über große Teile oder das gesamte Energieversorgungsnetz erstrecken, schnell und einfach eingesetzt werden.

Bei einer weiteren Ausführungsform weist der Impedanzwandler einen Verstärker mit einstellbarer Verstärkung auf. Dadurch können Antwortsignale von dem zu prüfenden Spannungswandler auf einen Messbereich des Frequenzgang-Analysators eingestellt und angepasst werden. Ferner ist es möglich, eine Vielzahl von unterschiedlichen Spannungswandlern zu prüfen, welche einen weiten Bereich unterschiedlicher Übersetzungsverhältnisse zwischen Primärseite und Sekundärseite aufweisen können.

Die Erfindung betrifft ferner ein Verfahren zum Prüfen eines Spannungswandlers. Bei dem Verfahren wird eine Vorrichtung wie oben beschrieben mit dem Frequenzgang-Analysator und dem Impedanzwandler bereitgestellt. Der Impedanzwandlerausgang des Impedanzwandlers wird mit dem Antwortsignaleingang des Frequenzgang-Analysators gekoppelt. Schließlich wird die Eingangsimpedanz des Impedanzwandlereingangs auf eine Impedanz des zu prüfenden Spannungswandlers eingestellt, sodass auch zwischen dem zu prüfenden Spannungswandler und dem Impedanzwandlereingang eine Impedanzanpassung vorliegt. Durch die Impedanzanpassung zwischen dem zu prüfenden Spannungswandler und dem Impedanzwandlereingang sowie zwischen dem Impedanzwandlerausgang und dem Antwortsignaleingang kann eine Übertragungsfunktion des Spannungswandlers genau ermittelt werden.

Gemäß einer Ausführungsform kann das Verfahren ein Kalibrieren des Frequenzgang-Analysators, des Impedanzwandlers und der verwendeten Messleitungen vorsehen. Das Verfahren umfasst beispielsweise ein Verbinden des Prüfsignalausgangs mit dem Referenzsignaleingang und dem Impedanzwandlereingang über Messleitungen, welche an dem Prüfsignalausgang, dem Referenzsignaleingang bzw. dem Impedanzwandlereingang angeschlossen sind. Beispielsweise kann ein erstes Ende einer ersten Messleitung an dem Prüfsignalausgang angeschlossen werden, ein erstes Ende einer zweiten Messleitung an dem Referenzsignaleingang angeschlossen werden und ein erstes Ende einer dritten Messleitung an dem Impedanzwandlereingang angeschlossen werden. Die zweiten Enden der drei Messleitungen werden miteinander verbunden. Wenn die Messleitungen Koaxialleitungen sind, werden die Innenleiter der zweiten Enden der drei Messleitungen miteinander verbunden und die Außenleiter der zweiten Enden der drei Messleitungen miteinander verbunden. Der Impedanzwandlerausgang des Impedanzwandlers ist, wie zuvor beschrieben, mit dem Antwortsignaleingang des Frequenzgang-Analysators verbunden.

Über den Prüfsignalausgang werden mehrere Prüfsignale bei unterschiedlichen Frequenzen ausgegeben. Entsprechende mehrere Kalibrierwerte werden an dem Referenzsignaleingang und an dem Antwortsignaleingang erfasst. Es ist klar, dass an dem Antwortsignaleingang das über den Prüfsignalausgang ausgegebene Prüfsignal über den Impedanzwandler erfasst wird, d.h. über die mit dem Impedanzwandlereingang verbundene dritte Messleitung und über die Kopplung zwischen dem Impedanzwandlerausgang und dem Antwortsignaleingang. Jeder Kalibrierwert der mehreren Kalibrierwerte ist einem entsprechenden Prüfsignal der mehreren Prüfsignale zugeordnet bzw. einer entsprechenden Frequenz des entsprechenden Prüfsignals.

Jeder Kalibrierwert der mehreren Kalibrierwerte kann beispielsweise eine Amplitude eines Spannungssignals an dem Referenzsignaleingang, eine Amplitude eines Spannungssignals an dem Antwortsignaleingang, ein Verhältnis zwischen der Amplitude des Spannungssignals an dem Referenzsignaleingang und der Amplitude des Spannungssignals an dem Antwortsignaleingang, und oder eine Phasendifferenz zwischen dem Spannungssignal an dem Referenzsignaleingang und dem Spannungssignal an dem Antwortsignaleingang umfassen.

Auf der Grundlage der Kalibrierwerte kann beispielsweise eine Verstärkung des Verstärkers des Impedanzwandlers eingestellt werden, um beispielsweise Spannungsabfälle auf den Messleitungen bei nachfolgenden Messungen an einem Spannungswandler zu berücksichtigen. Ebenso können durch die Messleitungen bedingte Phasendifferenzen bei nachfolgenden Messungen an einem Spannungswandler berücksichtigt werden.

Nach der Kalibrierung werden die Verbindungen zwischen den zweiten Enden der Messleitungen wieder getrennt.

Um einen Spannungswandler zu prüfen, kann beispielsweise die Übertragungsfunktion des Spannungswandlers bei verschiedenen Frequenzen bestimmt werden. Die Übertragungsfunktion kann beispielsweise ein Spannungsverhältnis zwischen einer Spannung an einer Eingangsseite und einer Spannung an einer Ausgangsseite des Spannungswandlers über einen vorgegebenen Frequenzbereich umfassen. Alternativ oder zusätzlich kann die Übertragungsfunktion beispielsweise einen Phasenversatz zwischen einer Spannung an der Eingangsseite und einer Spannung an der Ausgangsseite des Spannungswandlers über einen vorgegebenen Frequenzbereich umfassen.

Gemäß einer Ausführungsform können beispielsweise der Prüfsignalausgang und der Referenzsignaleingang über entsprechende Messleitungen mit einem ersten Anschluss des Spannungswandlers verbunden werden. Der erste Anschluss des Spannungswandlers kann beispielsweise ein Anschluss an einer Eingangsseite, beispielsweise einer Primärseite, des Spannungswandlers sein. Weiterhin kann der Impedanzwandlereingang über eine Messleitung mit einem zweiten Anschluss des Spannungswandlers verbunden werden. Der zweite Anschluss des Spannungswandlers kann beispielsweise ein Anschluss an einer Ausgangsseite, beispielsweise einer Sekundärseite des Spannungswandlers sein. Mehrere Prüfsignale werden über den Prüfsignalausgang bei unterschiedlichen Frequenzen ausgegeben und in den Spannungswandler eingespeist. Beispielsweise kann ein Signal mit einer bestimmten Spannung ausgegeben werden, dessen Frequenz sich zeitlich ändert. Zum Beispiel kann eine Wechselspannung konstanter Amplitude ausgegeben werden, deren Frequenz stetig einen vorgegebenen Bereich durchläuft, beispielsweise einen Bereich von wenigen Hertz bis einigen Megahertz, beispielsweise einen Bereich von 20 Hz bis 2 MHz. Derartige Signale werden auch als Sweep oder Chirp bezeichnet.

Während die Prüfsignale über den Prüfsignalausgang ausgegeben werden, werden mehrere Messwerte an dem Referenzsignaleingang und an dem Antwortsignaleingang erfasst. Es ist klar, dass zur Erfassung der Messwerte an dem Antwortsignaleingang Signale von dem Spannungswandler über den Impedanzwandlereingang, den Impedanzwandler einschließlich Verstärker, den Impedanzwandlerausgang und die Kopplung zwischen Impedanzwandlerausgang und Antwortsignaleingang empfangen werden. Jeder Messwert der mehreren Messwerte wird einem entsprechenden Prüfsignal der mehreren Prüfsignale zugeordnet. Jeder Messwert der mehreren Messwerte kann beispielsweise eine Amplitude des Spannungssignals an dem Referenzsignaleingang, eine Amplitude des Spannungssignals an dem Antwortsignaleingang, ein Verhältnis zwischen der Amplitude des Spannungssignals an dem Referenzsignaleingang und einer Amplitude des Spannungssignals an dem Antwortsignaleingang, und eine Phasendifferenz zwischen dem Spannungssignal an dem Referenzsignaleingang und dem Spannungssignal an dem Antwortsignaleingang umfassen.

Die verwendeten Messleitungen sowie die Anschlüsse, an denen die Messleitungen mit dem Spannungswandler und der Vorrichtung gekoppelt sind, weisen üblicherweise eine Impedanz auf, welche frequenzabhängig sein kann. Um die Übertragungsfunktion des Spannungswandlers möglichst genau zu bestimmen, ist es wünschenswert, Auswirkungen dieser (frequenzabhängigen) Impedanzen zu berücksichtigen und herauszurechnen. Genaue Angaben über entsprechende Impedanzen sind teilweise nicht verfügbar oder können veränderlich sein, beispielsweise aufgrund der unterschiedlichen Geometrien bei den Anschlüssen oder durch unterschiedliche Leitungsführungen der Messleitungen. Sofern, wie zuvor beschrieben, Kalibrierwerte ermittelt wurden, können diese Kalibrierwerte verwendet werden, um die erfassten Messwerte zu korrigieren, sodass zumindest eine Beeinflussung der Messwerte durch die (frequenzabhängigen) Impedanzen der Messleitungen im Wesentlichen berücksichtigt werden können. Gemäß einer Ausführungsform wird ein Messwert der mehreren Messwerte unter Verwendung eines entsprechenden Kalibrierwerts korrigiert, wobei der Messwert und der entsprechende Kalibrierwert einem jeweiligen Prüfsignal mit gleicher Frequenz zugeordnet sind. Beispielsweise kann bei einer jeweiligen Frequenz von einem dieser Frequenz zugeordneter Messwert ein entsprechender dieser Frequenz zugeordneter Kalibrierwert abgezogen werden.

Sofern eine Korrektur der Messwerte mittels der Kalibrierwerte durchgeführt wird, betreffen in den nachfolgenden Ausführungsformen die Messwerte vorzugsweise die mittels der Kalibrierwerte korrigierten Messwerte.

Gemäß einer Ausführungsform wird ein Spannungsverhältnisfehler zwischen einem erwarteten Spannungssignal und einem gemessenen Spannungssignal bei den unterschiedlichen Frequenzen basierend auf den mehreren Messwerten bestimmt. Ein erwartetes Spannungssignal kann beispielsweise auf der Grundlage eines Spannungssignals an dem Referenzsignaleingang und einem Übersetzungsverhältnis des Spannungswandlers bestimmt werden. Beispielsweise kann für verschiedene Frequenzen basierend auf der Amplitude des Spannungssignals an dem Antwortsignaleingang und basierend auf der Amplitude des Spannungssignals an dem Referenzsignaleingang unter Berücksichtigung eines Übersetzungsverhältnisses des Spannungswandlers ein jeweiliger Spannungsverhältnisfehler bestimmt werden. Weiterhin kann ein Phasenversatz bei unterschiedlichen Frequenzen basierend auf den Messwerten bestimmt werden. Beispielsweise kann ein Phasenversatz zwischen dem Spannungssignal an dem Antwortsignaleingang und dem Spannungssignal an dem Referenzsignaleingang für unterschiedliche Frequenzen bestimmt werden.

Der Spannungsverhältnisfehler bzw. der Phasenversatz bei den unterschiedlichen Frequenzen können auf einer Anzeigevorrichtung dargestellt werden, welche mit dem Frequenzgang-Analysator gekoppelt ist. Die Anzeigevorrichtung kann beispielsweise eine Anzeigevorrichtung auf einem mit dem Frequenzgang-Analysator gekoppelten Notebook, Tablet PC oder Smartphone sein.

Weiterhin können basierend auf den ermittelten mehreren Messwerten charakteristische Werte des Spannungswandlers bestimmt werden. Charakteristische Werte eines Spannungswandlers umfassen beispielsweise eine Frequenz bei einem Spannungsverhältnisfehler von 2%, eine Frequenz bei einem Spannungsverhältnisfehler von 5%, eine Frequenz bei einem Spannungsverhältnisfehler von 10%, eine Resonanzfrequenz, und/oder ein Spannungsverhältnisfehler bei einer Frequenz von 50 Hz.

Die charakteristischen Werte des Spannungswandlers können ebenfalls auf einer mit dem Frequenzgang-Analysator gekoppelten Anzeigevorrichtung angezeigt werden und beispielsweise für eine Langzeitüberwachung gespeichert werden, beispielsweise auf einem Notebook, Tablet PC oder Smartphone.

Anhand des Spannungsverhältnisfehlers und des Phasenversatzes sowie der charakteristischen Werte kann ein Zustand eines Spannungswandlers bestimmt werden, beispielsweise durch Vergleich mit entsprechenden Sollwerten oder entsprechenden Werten bei der Inbetriebnahme oder durch Beobachtung einer Veränderung dieser Werte über einen längeren Zeitraum. Dadurch kann festgestellt werden, ob sich der Spannungswandler in einem ordnungsgemäßen Zustand befindet.

Das zuvor beschriebene Verfahren kann beispielsweise mittels der zuvor beschriebenen Vorrichtung durchgeführt werden.

KURZE BESCHREIBUNG DER FIGUREN

Die Erfindung wird nachfolgend unter Bezugnahme auf die Zeichnungen anhand bevorzugter Ausführungsformen näher erläutert. In den Zeichnungen bezeichnen identische Bezugzeichen identische Elemente.

Fig. 1 zeigt schematisch eine Vorrichtung zum Prüfen eines Spannungswandlers gemäß einer Ausführungsform der vorliegenden Erfindung in Verbindung mit einem zu prüfenden konventionellen Spannungswandler.

Fig. 2 zeigt schematisch die Vorrichtung zum Prüfen eines Spannungswandlers der Fig. 1 in Verbindung mit einem zu prüfenden LPVT (beispielsweise ein ohmsch-kapazitiver Spannungsteiler).

Fig. 3 zeigt Verfahrensschritte zum Prüfen eines Spannungswandlers gemäß einer Ausführungsform.

DETAILLIERTE BESCHREIBUNG VON AUSFÜHRUNGSBEISPIELEN

Nachfolgend wird die vorliegende Erfindung anhand bevorzugter Ausführungsformen unter Bezugnahme auf die Figuren näher erläutert. In den Figuren bezeichnen gleiche Bezugzeichen gleiche oder ähnliche Elemente. Die Figuren sind schematische Darstellungen verschiedener Ausführungsformen der Erfindung. In den Figuren dargestellte Elemente sind nicht notwendigerweise maßstabsgetreu dargestellt. Vielmehr sind die verschiedenen in den Figuren dargestellten Elemente derart wiedergegeben, dass ihre Funktion und ihr Zweck dem Fachmann verständlich werden.

In den Figuren dargestellte Verbindungen und Kopplungen zwischen funktionellen Einheiten und Elementen können als direkte oder indirekte Verbindungen oder Kopplungen implementiert werden. Eine Verbindung oder Kopplung kann drahtgebunden oder drahtlos implementiert sein.

Nachfolgend werden Verfahren und Vorrichtungen zum Prüfen eines Spannungswandlers detailliert beschrieben. Der Zustand eines konventionellen Spannungswandlers (d.h., induktiven Spannungswandlers) kann durch Defekte an den Wicklungen, beispielsweise Isolationsfehler oder Verlagerungen der Wicklungen beeinträchtigt werden. Der Zustand eines LPVT kann durch Defekte an den Kondensatoren beziehungsweise ohmschen Komponenten des RC-Spannungsteilers beeinträchtigt werden. Es gibt verschiedene Gründe für diese Defekte, beispielsweise ein Eindringen von Feuchtigkeit in die Isolierung. Eine Überprüfung eines Spannungswandlers kann dazu beitragen, um eine Fehlsteuerung eines Energieübertragungsnetzes aufgrund von fehlerhaften Messwerten von dem Spannungswandler zu verhindern oder um einen Totalausfall des Spannungswandlers zu verhindern. Ein Totalausfall kann andere Einrichtungsteile oder Menschen gefährden.

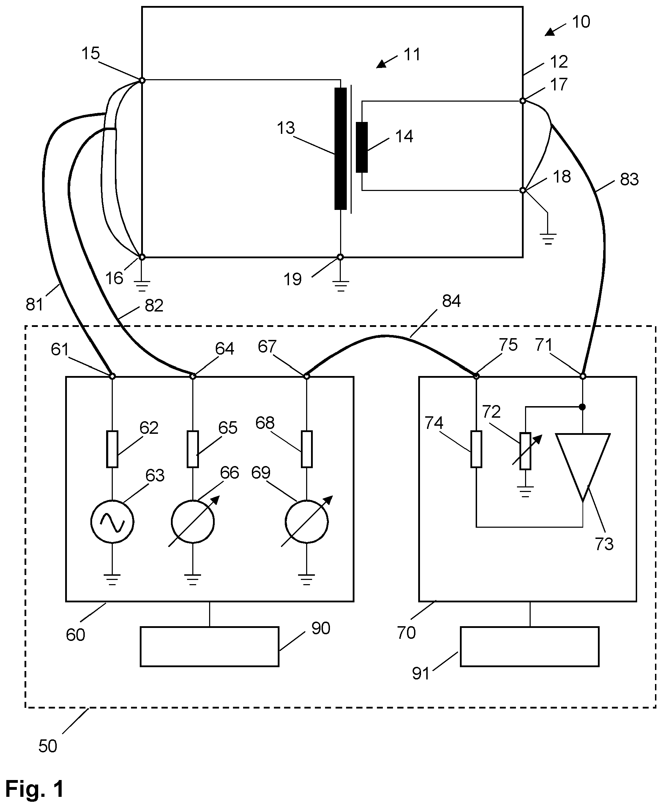

Fig. 1 zeigt schematisch einen konventionellen induktiven Spannungswandler 10. Der Spannungswandler 10 umfasst einen Transformator 11, welcher in einem Gehäuse 12 angeordnet ist. Der Transformator 11 umfasst eine Primärwicklung 13 und eine Sekundärwicklung 14. Die Primärwicklung 13 und die Sekundärwicklung 14 bestimmen ein Übersetzungsverhältnis Ü des Transformators 11. Ein Ende der Primärwicklung 13 ist mit einem Anschluss 15 verbunden und ein anderes Ende der Primärwicklung 13 ist mit einem Anschluss 19 verbunden, welcher mit Masse gekoppelt ist. Die Sekundärwicklung 14 ist mit zwei Anschlüssen 17 und 18 verbunden. Bezugszeichen 16 bezeichnet einen Masseanschluss des Gehäuses 12. Eine Ausgangsimpedanz des Spannungswandlers 10, wie sie beispielsweise an den Anschlüssen 17 und 18 gemessen werden kann, wird im Wesentlichen durch die Sekundärwicklung 14 bestimmt und kann beispielsweise im Bereich von einigen Ohm bis zu einigen 100 Ohm oder einigen Kiloohm liegen.

Fig. 1 zeigt weiterhin eine Vorrichtung 50 zum Prüfen des Spannungswandlers 10. Die Vorrichtung 50 umfasst einen Frequenzgang-Analysator 60 und einen Impedanzwandler 70. Der Frequenzgang-Analysator 60 und der Impedanzwandler 70 sind in Fig. 1 als zwei getrennte Einheiten dargestellt, können jedoch als eine Einheit oder zumindest in einem gemeinsamen Gehäuse integriert ausgebildet sein.

Der Frequenzgang-Analysator 60 umfasst eine Signalerzeugungsvorrichtung 63 mit einer Ausgangsimpedanz 62, welche ausgestaltet ist, ein Prüfsignal mit variabler Frequenz und einer vorgegebenen Spannung an einem Prüfsignalausgang 61 auszugeben. Das Prüfsignal kann beispielsweise ein Niederspannungssignal mit einer Spannung von beispielsweise 10 V sein. Die Signalerzeugungsvorrichtung 63 kann beispielsweise eine sinusförmige Spannung mit kontinuierlich steigender Frequenz ausgeben, beispielsweise in einem Frequenzbereich von 10 Hz bis 10 MHz, oder beispielsweise in einem Bereich von 20 Hz bis 2 MHz.

Der Frequenzgang-Analysator 60 umfasst ferner eine Referenzsignalerfassungsvorrichtung 66 mit einer Eingangsimpedanz 65, welche mit einem Referenzsignaleingang 64 gekoppelt ist.

Weiterhin umfasst der Frequenzgang-Analysator 60 eine Messsignalerfassungsvorrichtung 69 mit einer Eingangsimpedanz 68, welche mit einem Antwortsignaleingang 67 gekoppelt ist.

Der Frequenzgang-Analysator 60 kann eine Vorrichtung sein, welche für eine SFRA-Messung (engl. Sweep Frequency Response Analysis) an Leistungstransformatoren verwendet werden kann. Die Ausgangsimpedanz 62 und die Eingangsimpedanzen 65, 68 können beispielsweise jeweils 50 Ohm betragen.

Während der Frequenzgang-Analysator 60 beispielsweise eine sinusförmige Prüfspannung mit kontinuierlich steigender Frequenz an dem Prüfsignalausgang 61 ausgibt, kann der Frequenzgang-Analysator 60 ein Referenzsignal an dem Referenzsignaleingang 64 und ein Antwortsignal an dem Antwortsignaleingang 67 empfangen und das Antwortsignal zu dem Referenzsignal in Bezug setzen.

Der Frequenzgang-Analysator 60 kann beispielsweise von einer Batterie 90 mit elektrischer Energie für den Betrieb des Frequenzgang-Analysators 60 versorgt werden.

Die Vorrichtung 50 umfasst weiterhin den Impedanzwandler 70. Der Impedanzwandler 70 weist einen Impedanzwandlereingang 71 mit einer einstellbaren Eingangsimpedanz 72 auf. Die Eingangsimpedanz 72 kann beispielsweise in einem Bereich von einigen wenigen Ohm bis zu einigen Megaohm eingestellt werden. Die Eingangsimpedanz kann beispielsweise in einem Bereich von 1 Ohm bis 10 Megaohm einstellbar sein. Der Impedanzwandler 70 umfasst weiterhin einen Verstärker 73, beispielsweise einen Operationsverstärker, mit einstellbarer Verstärkung. Die Verstärkung kann in einem Bereich von 1 bis einigen 1000, beispielsweise bis 2000 oder 10.000, einstellbar sein. Ein Ausgang des Verstärkers 73 ist über eine Ausgangsimpedanz 74 mit einem Impedanzwandlerausgang 75 verbunden. Die Ausgangsimpedanz 74 kann beispielsweise gleich der Eingangsimpedanz 68 des Frequenzgang-Analysators 60 sein, also beispielsweise 50 Ohm betragen. Der Impedanzwandler 70 kann beispielsweise von einer Batterie 91 mit elektrischer Energie für den Betrieb des Impedanzwandlers 70 versorgt werden. Die Batterien 90, 91 können als getrennte Batterien vorgesehen sein oder als eine gemeinsame Batterie. Die Batterien 90, 91 können wiederaufladbare Batterien sein. Alternativ oder zusätzlich können der Frequenzgang-Analysator 60 und der Impedanzwandler 70 über ein Netzgerät mit elektrischer Energie versorgt werden.

Zur Prüfung des Spannungswandlers 10 wird die Primärseite des Transformators 11 mit dem Prüfsignalausgang 61 und dem Referenzsignaleingang 64 gekoppelt. Entsprechende Leitungen 81, 82, welche üblicherweise auch als Messleitungen bezeichnet werden, können beispielsweise als Koaxialleitungen ausgebildet sein. Die Außenleiter der Koaxialleitungen 81, 82 werden an dem Frequenzgang-Analysator 60 jeweils mit Masse verbunden, beispielsweise über ein Gehäuse des Frequenzgang-Analysators 60. An dem Spannungswandler 10 werden die Außenleiter der Koaxialleitungen 81, 82 jeweils mit der Gehäusemasse 16 verbunden. Der Innenleiter der Koaxialleitung 81 wird an dem Frequenzgang-Analysator 60 mit dem Prüfsignalausgang 61 verbunden und an dem Spannungswandler 10 mit dem Anschluss 15, welcher mit der Primärwicklung 13 des Transformators 11 gekoppelt ist. Der Innenleiter der Koaxialleitung 82 wird an dem Frequenzgang-Analysator 60 mit dem Referenzsignaleingang 64 verbunden und an dem Spannungswandler 10 mit dem Anschluss 15. Über den Referenzsignaleingang 64 erfasst die Referenzsignalerfassungsvorrichtung 66 somit das Prüfsignal von der Signalerzeugungsvorrichtung 63, wie es in den Spannungswandler 10 eingespeist wird, d.h., unter Berücksichtigung etwaiger Störungen oder Verluste durch die Übertragung über die Koaxialleitung 81. Es ist klar, dass die Leitungen 81, 82 auf beliebige andere Art und Weise realisiert werden können, beispielsweise in Form von verdrillten Leitungen oder als einzelne Leitungen, welche nur das Prüfsignal bzw. das Referenzsignal übertragen, aber keine Masseverbindung herstellen. Eine entsprechende Masseverbindung kann in diesem Fall über eine gesonderte Verbindung zwischen der Vorrichtung 50 und dem Spannungswandler 10 hergestellt werden.

Eine weitere Leitung 83, insbesondere eine Messleitung, beispielsweise eine Koaxialleitung, verbindet die Sekundärseite des Spannungswandlers 10 mit dem Impedanzwandlereingang 71. Beispielsweise kann an dem Spannungswandler 10 ein Innenleiter der Koaxialleitung 83 über den Anschluss 17 mit einer Seite der Sekundärwicklung 14 des Transformators 11 verbunden werden und ein Außenleiter der Koaxialleitung 83 über den Anschluss 18 mit einer anderen Seite der Sekundärwicklung 14 verbunden werden. Der Anschluss 18 kann zusätzlich mit Masse verbunden sein. An dem Impedanzwandler 70 kann der Innenleiter der Koaxialleitung 83 mit dem Impedanzwandlereingang 71 verbunden werden und der Außenleiter der Koaxialleitung 83 mit Masse, beispielsweise über ein Gehäuse des Impedanzwandlers 70.

Über eine Leitung 84, insbesondere eine weitere Messleitung, beispielsweise eine Koaxialleitung, ist der Impedanzwandlerausgang 75 mit dem Antwortsignaleingang 67 verbunden. Beispielsweise können an dem Impedanzwandler 70 ein Innenleiter der Koaxialleitung 84 mit dem Impedanzwandlerausgang 75 verbunden werden und ein Außenleiter der Koaxialleitung 84 mit Masse, beispielsweise über das Gehäuse des Impedanzwandlers 70. An dem Frequenzgang-Analysator 60 kann der Innenleiter der Koaxialleitung 84 mit dem Antwortsignaleingang 67 verbunden werden und der Außenleiter der Koaxialleitung 84 mit Masse, beispielsweise über das Gehäuse des Frequenzgang-Analysators 60.

Die Leitungen 83, 84 können auf beliebige andere Art und Weise realisiert werden, beispielsweise als verdrillte Leitungen oder als einzelne Leitungen, welche nur das Antwortsignal von dem Spannungswandler 10 zu dem Impedanzwandler 70 übertragen bzw. das Impedanz-angepasste Antwortsignal von dem Impedanzwandler 70 zu dem Frequenzgang-Analysator 60 übertragen, aber keine Masseverbindung herstellen. Eine entsprechende Masseverbindung kann über gesonderte Verbindungen zwischen dem Spannungswandler 10, dem Impedanzwandler 70 und dem Frequenzgang-Analysator 60 hergestellt werden.

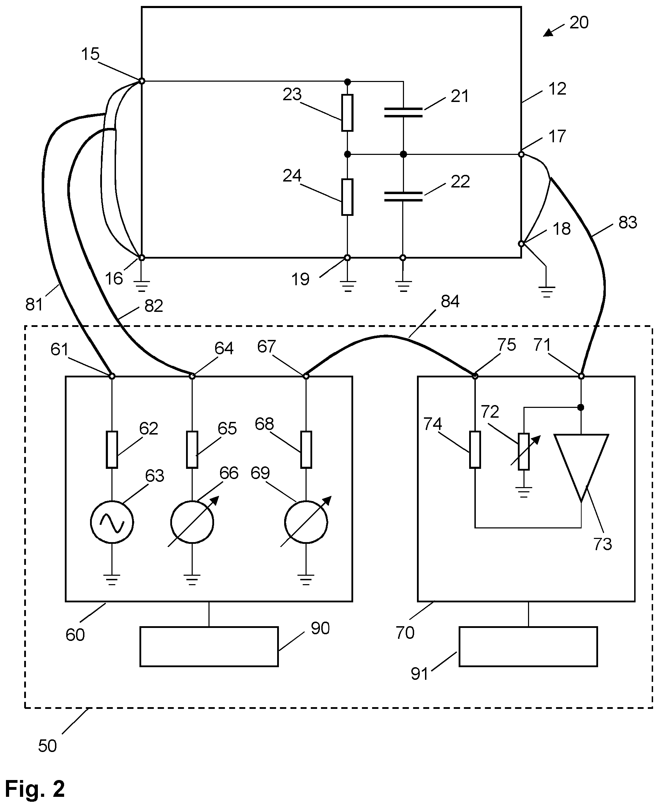

Fig. 2 zeigt schematisch einen Spannungswandler 20 vom Typ eines ohmsch-kapazitiven LPVT. Der Spannungswandler 20 umfasst eine Reihenschaltung von zwei Kondensatoren 21 und 22, welche als kapazitive Spannungsteiler arbeiten. Die Reihenschaltung ist mit den Anschlüssen 15 und 19 verbunden. Parallel dazu ist ein ohmscher Widerstandsteiler 23 und 24 geschaltet. Eine Ausgangsimpedanz des Spannungswandlers 20, wie er an den Anschlüssen 17 und 18 gemessen werden kann, wird daher im Wesentlichen durch den Kondensator 22 und den Widerstand 24 bestimmt. Im Gegensatz zu der Ausgangsimpedanz des in Fig. 1 gezeigten Spannungswandlers 10, welche im Bereich von einigen Ohm bis einige Kiloohm liegen kann, kann die Ausgangsimpedanz des Spannungswandlers 20 im Bereich von einigen 100 Kiloohm bis zu einigen Megaohm betragen. Ein Übersetzungsverhältnis des ohmsch-kapazitiven Spannungswandlers 20 wird sowohl durch die Kapazitäten $C_1$ und $C_2$ der Kondensatoren 21 bzw. 22 als auch durch die ohmschen Werte $R_1$ und $R_2$ der Widerstände 23 bzw. 24 bestimmt. Eine komplexe Übertragungsfunktion $\underline{k}R(j\omega) = \underline{U_2}/\underline{U_1}$ mit der komplexen Spannung $\underline{U_1}$ zwischen den Anschlüssen 15 und 16 und der komplexen Spannung $\underline{U_2}$ zwischen den Anschlüssen 17 und 18 beträgt:

$$\underline{k}_R(j\omega) = \frac{\underline{U_2}}{\underline{U_1}} = \frac{\underline{Z_2}}{\underline{Z}_{ges}} = \frac{R_2}{R_2 + R_1 \cdot \left(\frac{1 + j\omega C_2 R_2}{1 + j\omega C_1 R_1}\right)}$$

Der in Fig. 2 gezeigte ohmsch-kapazitive Spannungswandler 20 ist auf gleiche Art und Weise wie der in Fig. 1 gezeigte induktive Spannungswandler 10 mit der Vorrichtung 50 unter Verwendung der Messleitungen 81 bis 83 verbunden.

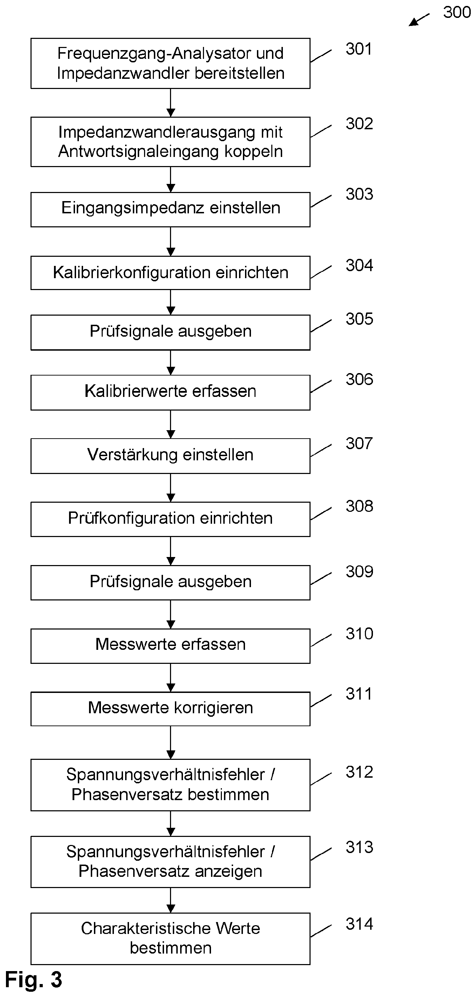

Unter Bezugnahme auf Fig. 3 wird nachfolgend ein Verfahren 300 zum Prüfen eines Spannungswandlers mit der in den Fig. 1 und 2 gezeigten Vorrichtung 50 im Detail beschrieben werden.

Im Schritt 301 werden der Frequenzgang-Analysator 60 und der Impedanzwandler 70 in der Nähe des zu prüfenden Spannungswandlers bereitgestellt. Der Spannungswandler kann beispielsweise den in Fig. 1 gezeigten induktiven Spannungswandler 10 oder den in Fig. 2 gezeigten ohmsch-kapazitiven Spannungswandler 20 umfassen. Im Schritt 302 wird der Impedanzwandlerausgang 75 des Impedanzwandlers 70 mit dem Antwortsignaleingang 67 des Frequenzgang-Analysators 60 über die Leitung 84 gekoppelt. Wie zuvor beschrieben, entspricht die Ausgangsimpedanz 74 des Impedanzwandlers 70 an dem Impedanzwandlerausgang 75 im Wesentlichen der Eingangsimpedanz 68 des Frequenzgang-Analysators 60 an dem Antwortsignaleingang 67.

In Abhängigkeit von dem zu prüfenden Spannungswandler 10, 20 wird im Schritt 303 die Eingangsimpedanz 72 des Impedanzwandler 70 eingestellt. Die Ausgangsimpedanz des Spannungswandlers 10, 20 kann entweder messtechnisch erfasst werden oder von einem Typenschild des Spannungswandlers übernommen werden oder daraus bestimmt werden, Beispielsweise aus der auf dem Typenschild des Spannungswandlers angegebenen Bürde.

Optional kann in den Schritten 304-306 eine Kalibrierung der Vorrichtung 50 unter Berücksichtigung der Messleitungen 81-83 durchgeführt werden. Dazu kann im Schritt 304 eine Kalibrierungskonfiguration eingerichtet werden. Die Leitung 81 wird an den Prüfsignalausgang 61 angeschlossen, die Leitung 82 an den Referenzsignaleingang 64 angeschlossen und die Leitung 83 an den Impedanzwandlereingang 71 angeschlossen. Die drei freien Enden der Leitungen 81, 82 und 83 werden direkt miteinander verbunden. Falls es sich bei den Leitungen 81, 82 und 83 um Koaxialleitungen handelt, werden die Innenleiter der Leitungen 81, 82 und 83 direkt miteinander verbunden und getrennt davon werden die Außenleiter der Leitungen 81, 82 und 83 direkt miteinander verbunden. Im Schritt 305 werden Prüfsignale von der Signalerzeugungsvorrichtung 63 erzeugt und über den Prüfsignalausgang 61 ausgegeben. Die Prüfsignale können beispielsweise sogenannte Chirp-Signale umfassen, also beispielsweise ein Signal, dessen Frequenz sich zeitlich ändert. Die Prüfsignale können beispielsweise sogenannte Sweep-Signale umfassen, d.h., eine Wechselspannung konstanter Amplitude, deren Frequenz periodisch und stetig einen vorgegebenen Bereich durchläuft. Die Prüfsignale können beispielsweise Spannungssignale mit einer Amplitude im Bereich von einigen Volt, beispielsweise 10 V umfassen.

Während die Prüfsignale im Schritt 305 ausgegeben werden, werden im Schritt 306 an dem Referenzsignaleingang 64 und (über den Impedanzwandler 50) an dem Prüfsignaleingang 67 jeweils entsprechende Kalibrierwerte, beispielsweise Spannungssignale erfasst. Übertragungseigenschaften von insbesondere der Leitung 82, der Leitung 83, dem Impedanzwandler 70 und der Leitung 84 können durch Analyse der Kalibrierwerte ermittelt werden und nachfolgend zur Korrektur von Messwerten bei der Prüfung des Spannungswandlers 10, 20 verwendet werden. Ein Kalibrierwert kann beispielsweise ein Spannungssignal an dem Referenzsignaleingang und ein weiterer Kalibrierwert kann beispielsweise ein Spannungssignal an dem Antwortsignaleingang umfassen. Zusätzliche Kalibrierwerte können aus den erfassten Kalibrierwerten bestimmt werden. Beispielsweise kann ein Amplitudenverhältnis zwischen der Amplitude des Spannungssignals an dem Referenzsignaleingang und einer Amplitude eines Spannungssignals an dem Antwortsignaleingang als ein zusätzlicher Kalibrierwert bestimmt werden. Beispielsweise kann eine Phasendifferenz zwischen dem Spannungssignal an dem Referenzsignaleingang und dem Spannungssignal an dem Antwortsignaleingang als ein zusätzlicher Kalibrierwert bestimmt werden. Die erfassten und zusätzlich bestimmten Kalibrierwerte können bei unterschiedlichen Frequenzen erfasst bzw. für unterschiedliche Frequenzen bestimmt werden und den unterschiedlichen Frequenzen zugeordnet werden. Beispielsweise können einigen oder allen der mehreren unterschiedlichen Frequenzen, mit denen das Prüfsignal ausgegeben wurde, jeweils entsprechende Amplitudenverhältnisse und Phasendifferenzen zugeordnet werden.

Am Ende der Kalibrierung werden die direkt miteinander verbundenen Enden der Leitungen 81, 82 und 83 voneinander getrennt.

Als nächstes wird im Schritt 307 die Verstärkung des Verstärkers 73 des Impedanzwandlers 70 eingestellt. Bei der Einstellung der Verstärkung können beispielsweise Erkenntnisse aus der vorhergehenden Kalibrierung berücksichtigt werden. Beispielsweise kann das Amplitudenverhältnis bei einer bestimmten Frequenz oder ein Mittelwert der Amplitudenverhältnisse über einen bestimmten Frequenzbereich ermittelt werden, um die Verstärkung des Verstärkers 73 derart einzustellen, dass das Amplitudenverhältnis im Wesentlichen ausgeglichen wird. Weiterhin kann bei der Einstellung der Verstärkung des Verstärker 73 ein Übersetzungsverhältnis des Spannungswandlers berücksichtigt werden sowie eine Eingangsempfindlichkeit des Antwortsignaleingangs, sodass ein aufgrund des Prüfsignals zu erwartender Spannungsbereich am Ausgang des Spannungswandlers 10 innerhalb des Messbereichs der Messsignalerfassungsvorrichtung 69 liegt und diesen auch möglichst ausschöpft.

Im Schritt 308 wird eine Prüfkonfiguration in Verbindung mit dem Spannungswandler 10 bzw. 20 eingerichtet. Wie in Fig. 1 und Fig. 2 gezeigt, wird der Prüfsignalausgang 61 über die Leitung 81 mit dem Anschluss 15 des Spannungswandlers 10 bzw. 20 gekoppelt. Sofern die Leitung 81 auch eine Masseverbindung führt, wird diese mit der Masse 16 des Gehäuses 12 des Spannungswandlers 10, 20 verbunden. Der Referenzsignaleingang 64 wird über die Leitung 82 ebenfalls mit dem Anschluss 15 des Spannungswandlers 10, 20 verbunden und, sofern die Leitung 82 eine Masseverbindung führt, wird diese mit dem Anschluss 16 (Masse) des Gehäuses 12 des Spannungswandlers 10, 20 verbunden. Der Impedanzwandler 71 wird über die Leitung 83 mit dem Anschluss 17 des Spannungswandlers 10, 20 gekoppelt und, sofern die Leitung 83 eine Masseverbindung führt, wird diese mit Dem Anschluss 18 des Gehäuses 12 des Spannungswandlers 10,20 verbunden. Es ist zu beachten, dass die Leitung 84 nach wie vor den Impedanzwandlerausgang 75 mit dem Antwortsignaleingang 67 des Frequenzgang-Analysators 60 verbindet.

Im Schritt 309 werden Prüfsignale von der Signalerzeugungsvorrichtung 63 erzeugt und über den Prüfsignalausgang 61 und die Leitung 81 in die Primärseite des Spannungswandlers 10, 20 eingespeist. Die Prüfsignale können beispielsweise sogenannte Chirp-Signale umfassen, also beispielsweise ein Signal, dessen Frequenz sich zeitlich ändert. Die Prüfsignale können beispielsweise sogenannte Sweep-Signale umfassen, d.h., eine Wechselspannung konstanter Amplitude, deren Frequenz periodisch und stetig einen vorgegebenen Bereich durchläuft. Die Prüfsignale können beispielsweise Spannungssignale mit einer Amplitude im Bereich von einigen Volt, beispielsweise 10 V umfassen. Andere Prüfsignale sind möglich, beispielsweise Signale mit konstanter Frequenz und veränderlicher Amplitude, Impulssignale und dergleichen.

Während die Prüfsignale im Schritt 309 ausgegeben werden, werden im Schritt 310 an dem Referenzsignaleingang 64 und (über den Impedanzwandler 50) an dem Prüfsignaleingang 67 jeweils entsprechende Messwerte, beispielsweise Spannungssignale mittels der Referenzsignalerfassungsvorrichtung 66 bzw. der Messsignalerfassungsvorrichtung 69 erfasst. Übertragungseigenschaften des Spannungswandlers 10, 20 können durch Analyse dieser Messwerte ermittelt werden, beispielsweise mittels einer (nicht gezeigten) Verarbeitungsvorrichtung (z.B. ein Mikroprozessor mit zugeordnetem Speicher) des Frequenzgang-Analysators 60. Sofern die zuvor beschriebene Kalibrierung durchgeführt wurde, können im Schritt 311 die erfassten Messwerte mithilfe der Kalibrierwerte korrigiert werden. Insbesondere können dadurch Einflüsse der Leitung 82, der Leitung 83, des Impedanzwandlers 70 und der Leitung 84 auf die erfassten Messwerte korrigiert werden

Die Messwerte können beispielsweise ein Spannungssignal an dem Referenzsignaleingang und ein Spannungssignal an dem Antwortsignaleingang umfassen. Zusätzliche Werte können aus den erfassten Messwerten bestimmt werden. Beispielsweise kann ein Amplitudenverhältnis zwischen der Amplitude des Spannungssignals an dem Referenzsignaleingang und einer Amplitude des Spannungssignals an dem Antwortsignaleingang bestimmt werden. Ferner kann eine Phasendifferenz zwischen dem Spannungssignal an dem Referenzsignaleingang und dem Spannungssignal an dem Antwortsignaleingang bestimmt werden. Die erfassten Messwerte und die zusätzlich bestimmten Werte können bei unterschiedlichen Frequenzen erfasst bzw. für unterschiedliche Frequenzen bestimmt werden und den unterschiedlichen Frequenzen zugeordnet werden. Beispielsweise können einigen oder allen der mehreren unterschiedlichen Frequenzen, mit denen das Prüfsignal ausgegeben wurde, jeweils entsprechende Amplitudenverhältnisse und Phasendifferenzen zugeordnet werden.

Das Amplitudenverhältnis und/oder die Phasendifferenz können mittels entsprechender Werte aus der Kalibrierung korrigiert werden. Die Korrektur kann für eine jeweilige Frequenz, der das Amplitudenverhältnis bzw. die Phasendifferenz zugeordnet sind, durchgeführt werden.

Auf der Grundlage der so ermittelten Messwerte und zusätzlich bestimmten Werte kann eine Übertragungsfunktion des Spannungswandlers bestimmt werden. Beispielsweise kann im Schritt 312 ein Spannungsverhältnisfehler des Spannungswandlers ermittelt werden, insbesondere können Spannungsverhältnisfehler für die verschiedenen Frequenzen bestimmt werden, mit denen das Prüfsignal in den Spannungswandler eingespeist wurde. Ferner kann im Schritt 312 ein Phasenversatz des Spannungswandlers für die verschiedenen Frequenzen bestimmt werden. Im Schritt 313 können der Spannungsverhältnisfehler und/oder der Phasenversatz beispielsweise in Form eines Diagramms über der Frequenz auf eine Anzeigevorrichtung dargestellt werden.

Die Anzeigevorrichtung kann beispielsweise eine Anzeigevorrichtung eines an die Vorrichtung 50 angeschlossenen Notebooks, Tablet PCs oder Smartphones sein.

Weiterhin können im Schritt 314. auf der Grundlage der ermittelten Messwerte und der zusätzlich bestimmten Werte charakteristische Werte des Spannungswandlers 10, 20 berechnet und zur Anzeige gebracht werden. Ein charakteristischer Wert des Spannungswandlers 10, 20 kann beispielsweise eine Frequenz bei einem Spannungsverhältnisfehler von 2 % sein. Beispielsweise kann ausgehend von einer Nennfrequenz von 50 Hz bestimmt werden, bis zu welcher höheren Frequenz der Spannungsverhältnisfehler weniger als 2 % beträgt. Die Frequenz, bei der der Spannungsverhältnisfehler zum ersten Mal 2 % oder mehr beträgt, kann als ein entsprechender charakteristischer Wert zur Anzeige gebracht werden. Ein entsprechender charakteristischer Wert kann beispielsweise ausgehend von der Nennfrequenz von 50 Hz in Richtung niedrigerer Frequenzen bestimmt werden. Weitere charakteristische Werte des Spannungswandlers können beispielsweise eine Frequenz bei einem Spannungsverhältnisfehler von 5 % oder 10 % sein. Ein weiterer charakteristischer Wert des Spannungswandlers kann die Resonanzfrequenz des Spannungswandlers 10, 20 sein, also beispielsweise die Frequenz, bei welcher bei konstanter Eingangsamplitude die größte Ausgangsamplitude erreicht wird oder das Ausgangssignal einen Phasenwinkel von 90° zum Eingangssignal aufweist. Als ein weiterer charakteristischer Wert kann der Spannungsverhältnisfehler bei Nennfrequenz, beispielsweise bei 50 Hz, bestimmt werden.

Zusammengefasst bietet die Kombination aus dem Frequenzgang-Analysator 60 und dem Impedanzwandler 70 die Möglichkeit, sowohl konventionelle induktive Spannungswandler 10 als auch LPVT Spannungswandler 20 zu prüfen. Darüber hinaus kann ein derartiger Frequenzgang-Analysator 60 in Verbindung mit dem Impedanzwandler 70 als eine kompakte von einer Bedienperson tragbaren Vorrichtung ausgebildet werden, sodass derartige Prüfungen auf einfache Art und Weise vor Ort durchgeführt werden können.

Das beschriebene Verfahren ist für Vor-Ort-Messungen geeignet, so dass die Integrität und das Übertragungsverhalten im eingebauten Zustand (z.B. bei einer Abnahme vor Ort oder bei einer Routinemessung) überprüft und die kritischen Frequenzen (beispielsweise bei Spannungsverhältnisfehlern von 2%, 5%, 10%) im Zeitverlauf überprüft bzw. angezeigt werden können. Darüber hinaus ist dieses Verfahren auch für Hersteller im Fertigungsprozess geeignet, da die verwendete Vorrichtung 50 kompakt und leicht ist und somit einfach in den Fertigungsprozess integriert werden kann. Ferner sind die verwendeten Spannungspegel niedrig, wodurch Gefährdungen des Bedienpersonals verringert werden können. Insbesondere durch die Impedanzanpassung und gegebenenfalls durch die Kalibrierung ist die Messung selbst sehr genau.

Der Impedanzwandler 70 hat nicht nur die Eigenschaft, dass er die Impedanz an die Nennlast des Spannungswandlers 10, 20 anpasst, sondern auch, dass er das auf der Sekundärseite des Spannungswandlers 10, 20 anliegende Signal verstärkt. Weiterhin hat dieser Messaufbau den Vorteil, dass die Verbindung zwischen dem Impedanzwandler 70 und der Sekundärseite des Spannungswandlers 10, 20 kurz gehalten werden kann, um Reflexionen zu vermeiden. Auf der anderen Seite des Impedanzwandlers wird eine (50 Ohm) Impedanzanpassung erreicht. Ferner kann mit diesem Messaufbau auf einfache Art und Weise eine Verstärkungs-/Phasenkalibrierung durchgeführt werden, z.B. eine Messaufbau-Kalibrierung.

## Patentansprüche

1. Vorrichtung zum Prüfen eines Spannungswandlers, umfassend:

   - einen Frequenzgang-Analysator (60), der ausgestaltet ist, eine elektrische Übertragungsfunktion über einen vorgegebenen Frequenzbereich zu messen, wobei der Frequenzgang-Analysator (60) einen Prüfsignalausgang (61) zum Ausgeben eines Prüfsignals für den Spannungswandler (10, 20), einen Referenzsignaleingang (64) zum Empfangen eines Referenzsignals, welches für das Prüfen des Spannungswandlers (10, 20) an dem Spannungswandler (10, 20) anliegt, und einen Antwortsignaleingang (67) mit einer vorgegeben Eingangsimpedanz (68) zum Empfangen eines Antwortsignals von dem Spannungswandler (10, 20) umfasst,

   **gekennzeichnet durch**

   - einen Impedanzwandler (70) mit einem Impedanzwandlereingang (71), welcher eine veränderliche, an eine Impedanz des Spannungswandlers (10, 20) einstellbare Eingangsimpedanz (72) aufweist, und einem Impedanzwandlerausgang (75), welcher mit dem Antwortsignaleingang (67) gekoppelt ist und eine an die Eingangsimpedanz (68) des Antwortsignaleingangs (67) angepasste Ausgangsimpedanz (74) aufweist.

2. Vorrichtung nach Anspruch 1, wobei die Eingangsimpedanz (72) des Impedanzwandlereingangs (71) in einem Bereich von 30 Ohm bis 100 Megaohm, vorzugsweise in einem Bereich von 50 Ohm bis 100 Megaohm einstellbar ist.

3. Vorrichtung nach Anspruch 1 oder Anspruch 2, wobei die vorgegebene Eingangsimpedanz (68) des Antwortsignaleingangs (67) des Frequenzgang-Analysators (60) 50 Ohm beträgt.

4. Vorrichtung nach einem der vorhergehenden Ansprüche, wobei eine Ausgangsimpedanz (62) an dem Prüfsignalausgang (61) des Frequenzgang-Analysators (60) 50 Ohm beträgt und eine Eingangsimpedanz (65) des Referenzsignaleingangs (64) des Frequenzgang-Analysators (60) 50 Ohm beträgt.

5. Vorrichtung nach einem der vorhergehenden Ansprüche, wobei die Vorrichtung (50) mindestens eine Batterie (90, 91) umfasst, welche ausgestaltet ist, elektrische Energie zum Betrieb des Frequenzgang-Analysators (60) und/oder des Impedanzwandlers (70) bereitzustellen.

6. Vorrichtung nach einem der vorhergehenden Ansprüche, wobei die Vorrichtung (50) als eine mobile tragbare Vorrichtung ausgestaltet ist.

7. Verfahren zum Prüfen eines Spannungswandlers, wobei das Verfahren (300) umfasst:

   - Bereitstellen (301) einer Vorrichtung nach einem der Ansprüche 1-6,
   - Koppeln (302) des Impedanzwandlerausgangs (75) mit dem Antwortsignaleingang (67), und

- Einstellen (303) der Eingangsimpedanz (72) des Impedanzwandlers (70) auf eine Impedanz des Spannungswandlers (10, 20).

8. Verfahren nach Anspruch 7, ferner umfassend:

- Verbinden (304) des Prüfsignalausgangs (61) mit dem Referenzsignaleingang (64) und dem Impedanzwandlereingang (71) über Messleitungen (81-83), welche an dem Prüfsignalausgang (61), dem Referenzsignaleingang (64) bzw. dem Impedanzwandlereingang (71) angeschlossen sind,
- Ausgeben (305) mehrerer Prüfsignale über den Prüfsignalausgang (61) bei unterschiedlichen Frequenzen, und
- Erfassen (306) mehrerer Kalibrierwerte an dem Referenzsignaleingang (64) und dem Antwortsignaleingang (67) über den Impedanzwandler (70) und Impedanzwandlereingang (71), wobei jeder Kalibrierwert der mehreren Kalibrierwerte einem entsprechenden Prüfsignal der mehreren Prüfsignale zugeordnet ist.

9. Verfahren nach Anspruch 8, wobei jeder Kalibrierwert der mehreren Kalibrierwerte mindestens einen der folgenden Werte umfasst:

eine Amplitude eines Spannungssignals an dem Referenzsignaleingang (64),
ein Verhältnis zwischen der Amplitude des Spannungssignals an dem Referenzsignaleingang (64) und einer Amplitude eines Spannungssignals an dem Antwortsignaleingang (67), und
eine Phasendifferenz zwischen dem Spannungssignal an dem Referenzsignaleingang (64) und dem Spannungssignal an dem Antwortsignaleingang (67).

10. Verfahren nach Anspruch 8 oder Anspruch 9, ferner umfassend:

- Einstellen einer Verstärkung (307) eines Verstärkers (73) des Impedanzwandlers (70) in Abhängigkeit von mindestens einem der mehreren Kalibrierwerte.

11. Verfahren nach einem der Ansprüche 7 bis 10, ferner umfassend:

- Verbinden (308) des Prüfsignalausgangs (61) und des Referenzsignaleingangs (64) über Messleitungen (81, 82) mit einem ersten Anschluss (15) des Spannungswandlers (10, 20) und Verbinden (308) des Impedanzwandlereingangs (71) über eine Messleitung (83) mit einem zweiten Anschluss (17) des Spannungswandlers (10, 20),
- Ausgeben (309) mehrerer Prüfsignale über den Prüfsignalausgang (61) bei unterschiedlichen Frequenzen, und
- Erfassen (310) mehrerer Messwerte an dem Referenzsignaleingang (64) und dem Antwortsignaleingang (67) über den Impedanzwandler (70) und Impedanzwandlereingang (71), wobei jeder Messwert der mehreren Messwerte einem entsprechenden Prüfsignal der mehreren Prüfsignale zugeordnet ist.

12. Verfahren nach Anspruch 11, wobei jeder Messwert der mehreren Messwerte mindestens einen der folgenden Werte umfasst:

eine Amplitude eines Spannungssignals an dem Referenzsignaleingang (64),
ein Verhältnis zwischen der Amplitude des Spannungssignals an dem Referenzsignaleingang (64) und einer Amplitude eines Spannungssignals an dem Antwortsignaleingang (67), und
eine Phasendifferenz zwischen dem Spannungssignal an dem Referenzsignaleingang (64) und dem Spannungssignal an dem Antwortsignaleingang (67).

13. Verfahren nach Anspruch 11 oder Anspruch 12, ferner umfassend:

- Korrigieren (311) eines Messwerts der mehreren Messwerte unter Verwendung eines Kalibrierwerts, wobei der Messwert und der Kalibrierwert einem jeweiligen Prüfsignal mit gleicher Frequenz zugeordnet sind.

14. Verfahren nach einem der Ansprüche 11 bis 13, ferner umfassend:

- Bestimmen (312) eines Spannungsverhältnisfehlers und/oder eines Phasenversatzes bei den unterschiedlichen Frequenzen basierend auf den mehreren Messwerten, und
- Darstellen (313) des Spannungsverhältnisfehlers und/oder des Phasenversatzes bei den unterschiedlichen Frequenzen auf einer mit dem Frequenzgang-Analysator (60) gekoppelten Anzeigevorrichtung.

**15.** Verfahren nach einem der Ansprüche 11 bis 14, ferner umfassend:

- Bestimmen (314) von charakteristischen Werten des Spannungswandlers (10, 20) basierend auf den mehreren Messwerten, wobei die charakteristischen Werte mindestens einen Wert umfassen aus einer Gruppe umfassend:

- eine Frequenz bei einem Spannungsverhältnisfehler von 1%,
- eine Frequenz bei einem Spannungsverhältnisfehler von 5%,
- eine Frequenz bei einem Spannungsverhältnisfehler von 10%,
- eine Resonanzfrequenz, und
- einen Spannungsverhältnisfehler bei einer Frequenz von 50 Hz.

**Claims**

**1.** A device for testing a voltage converter, comprising:

- a frequency response analyser (60) which is configured to measure an electrical transfer function over a predefined frequency range, wherein the frequency response analyser (60) comprises a test signal output (61) for outputting a test signal for the voltage converter (10, 20), a reference signal input (64) for receiving a reference signal which is applied to the voltage converter (10, 20) for the purpose of testing the voltage converter (10, 20), and a response signal input (67) having a predefined input impedance (68) for receiving a response signal from the voltage converter (10, 20),

**characterized by**

- an impedance converter (70) having an impedance converter input (71), which has a variable input impedance (72) which can be adjusted to an impedance of the voltage converter (10, 20), and an impedance converter output (75), which is coupled to the response signal input (67) and has an output impedance (74) matched to the input impedance (68) of the response signal input (67).

**2.** The device according to claim 1, wherein the input impedance (72) of the impedance converter input (71) can be adjusted in a range of from 30 ohms to 100 megaohms, preferably in a range of from 50 ohms to 100 megaohms.

**3.** The device according to claim 1 or claim 2, wherein the predefined input impedance (68) of the response signal input (67) of the frequency response analyser (60) is 50 ohms.

**4.** The device according to any one of the preceding claims, wherein an output impedance (62) at the test signal output (61) of the frequency response analyser (60) is 50 ohms and an input impedance (65) of the reference signal input (64) of the frequency response analyser (60) is 50 ohms.

**5.** The device according to any one of the preceding claims, wherein the device (50) comprises at least one battery (90, 91) which is configured to provide electrical power for the purpose of running the frequency response analyser (60) and/or the impedance converter (70).

**6.** The device according to any one of the preceding claims, wherein the device (50) is configured as a mobile portable device.

**7.** A method of testing a voltage converter, wherein the method (300) comprises:

- providing (301) a device according to any one of claims 1-6,
- coupling (302) the impedance converter output (75) to the response signal input (67), and
- adjusting (303) the input impedance (72) of the impedance converter (70) to an impedance of the voltage converter (10, 20).

**8.** The method according to Claim 7, further comprising:

- connecting (304) the test signal output (61) to the reference signal input (64) and the impedance converter input (71) via measuring lines (81-83) which are connected to the test signal output (61), the reference signal input (64) and the impedance converter input (71) respectively,
- outputting (305) a plurality of test signals via the test signal output (61) at different frequencies, and
- acquiring (306) a plurality of calibration values at the reference signal input (64) and the response signal input (67) via the impedance converter (70) and impedance converter input (71), wherein each calibration value of the plurality of calibration values is assigned to a corresponding test signal of the plurality of test signals.

9. The method according to claim 8, wherein each calibration value of the plurality of calibration values comprises at least one of the following values:

an amplitude of a voltage signal at the reference signal input (64),
a ratio between the amplitude of the voltage signal at the reference signal input (64) and an amplitude of a voltage signal at the response signal input (67), and
a phase difference between the voltage signal at the reference signal input (64) and the voltage signal at the response signal input (67).

10. The method according to Claim 8 or Claim 9, further comprising:

- adjusting an amplification (307) of an amplifier (73) of the impedance converter (70) depending on at least one of the plurality of calibration values.

11. The method according to any one of Claims 7 to 10, further comprising:

- connecting (308) the test signal output (61) and the reference signal input (64) to a first terminal (15) of the voltage converter (10, 20) via measuring lines (81, 82) and connecting (308) the impedance converter input (71) to a second terminal (17) of the voltage converter (10, 20) via a measuring line (83),
- outputting (309) a plurality of test signals via the test signal output (61) at different frequencies, and
- acquiring (310) a plurality of measurement values at the reference signal input (64) and the response signal input (67) via the impedance converter (70) and impedance converter input (71), wherein each measurement value of the plurality of measurement values is assigned to a corresponding test signal of the plurality of test signals.

12. The method according to claim 11, wherein each measurement value of the plurality of measurement values comprises at least one of the following values:

an amplitude of a voltage signal at the reference signal input (64),
a ratio between the amplitude of the voltage signal at the reference signal input (64) and an amplitude of a voltage signal at the response signal input (67), and
a phase difference between the voltage signal at the reference signal input (64) and the voltage signal at the response signal input (67).

13. The method according to Claim 11 or Claim 12, further comprising:

- correcting (311) a measurement value of the plurality of measurement values using a calibration value, wherein the measurement value and the calibration value are assigned to a respective test signal with an identical frequency.

14. The method according to any one of Claims 11 to 13, further comprising:

- determining (312) a voltage ratio error and/or a phase shift at the different frequencies based on the plurality of measurement values, and
- depicting (313) the voltage ratio error and/or the phase shift at the different frequencies on a display device which is coupled to the frequency response analyser (60).

15. The method according to any one of Claims 11 to 14, further comprising:

- determining (314) characteristic values of the voltage converter (10, 20) based on the plurality of measurement values, wherein the characteristic values comprise at least one value from a group comprising:

- a frequency at a voltage ratio error of 1%,
- a frequency at a voltage ratio error of 5%,
- a frequency at a voltage ratio error of 10%,
- a resonant frequency, and
- a voltage ratio error at a frequency of 50 Hz.

**Revendications**

1. Dispositif pour tester un transformateur de tension, comprenant :

   - un analyseur de réponse en fréquence (60) qui est configuré pour mesurer une fonction de transfert électrique sur une plage de fréquences prédéterminée, l'analyseur de réponse en fréquence (60) ayant une sortie de signal de test (61) pour émettre un signal de test pour le transformateur de tension (10, 20), une entrée de signal de référence (64) pour recevoir un signal de référence qui est appliqué au transformateur de tension (10, 20) pour tester le transformateur de tension (10, 20), et une entrée de signal de réponse (67) ayant une impédance d'entrée prédéterminée (68) pour recevoir un signal de réponse du transformateur de tension (10, 20),

   **caractérisé en ce que**

   - un transformateur d'impédance (70) avec une entrée de transformateur d'impédance (71), qui présente une impédance d'entrée (72) variable, réglable sur une impédance du transformateur de tension (10, 20), et une sortie de transformateur d'impédance (75), qui est couplée à l'entrée de signal de réponse (67) et présente une impédance de sortie (74) adaptée à l'impédance d'entrée (68) de l'entrée de signal de réponse (67).

2. Dispositif selon la revendication 1, dans lequel l'impédance d'entrée (72) de l'entrée de transformateur d'impédance (71) est réglable dans une plage de 30 ohms à 100 mégohms, de préférence dans une plage de 50 ohms à 100 mégohms.

3. Dispositif selon la revendication 1 ou la revendication 2, dans lequel l'impédance d'entrée prédéterminée (68) de l'entrée de signal de réponse (67) de l'analyseur de réponse en fréquence (60) est de 50 ohms.

4. Dispositif selon l'une quelconque des revendications précédentes, dans lequel une impédance de sortie (62) à la sortie de signal de test (61) de l'analyseur de réponse en fréquence (60) est de 50 ohms et une impédance d'entrée (65) de l'entrée de signal de référence (64) de l'analyseur de réponse en fréquence (60) est de 50 ohms.

5. Dispositif selon l'une quelconque des revendications précédentes, dans lequel le dispositif (50) comprend au moins une batterie (90, 91) configurée pour fournir de l'énergie électrique pour le fonctionnement de l'analyseur de réponse en fréquence (60) et/ou du transformateur d'impédance (70).

6. Dispositif selon l'une quelconque des revendications précédentes, dans lequel le dispositif (50) est configuré comme un dispositif portable mobile.

7. Procédé pour tester un transformateur de tension, le procédé (300) comprenant :

   - fournir (301) un dispositif selon l'une quelconque des revendications 1 à 6,
   - coupler (302) la sortie de transformateur d'impédance (75) à l'entrée de signal de réponse (67), et
   - régler (303) l'impédance d'entrée (72) du transformateur d'impédance (70) à une impédance du transformateur de tension (10, 20).

8. Procédé selon la revendication 7, comprenant en outre :

   - relier (304) la sortie de signal de test (61) à l'entrée de signal de référence (64) et à l'entrée de transformateur d'impédance (71) par l'intermédiaire de lignes de mesure (81-83) qui sont raccordées à la sortie de signal de test (61), à l'entrée de signal de référence (64) et à l'entrée de transformateur d'impédance (71), respectivement,
   - émettre (305) une pluralité de signaux de test par l'intermédiaire de la sortie de signal de test (61) à des fréquences différentes, et
   - acquérir (306) une pluralité de valeurs d'étalonnage à l'entrée de signal de référence (64) et à l'entrée de signal de réponse (67) par l'intermédiaire du transformateur d'impédance (70) et de l'entrée de transformateur d'impédance (71), chaque valeur d'étalonnage de la pluralité de valeurs d'étalonnage étant associée à un signal de test correspondant de la pluralité de signaux de test.

9. Procédé selon la revendication 8, dans lequel chaque valeur d'étalonnage de la pluralité de valeurs d'étalonnage comprend au moins l'une des valeurs suivantes :

une amplitude d'un signal de tension à l'entrée de signal de référence (64),
un rapport entre l'amplitude du signal de tension à l'entrée de signal de référence (64) et une amplitude d'un signal de tension à l'entrée de signal de réponse (67), et une différence de phase entre le signal de tension à l'entrée de signal de référence (64) et le signal de tension à l'entrée de signal de réponse (67).

10. Procédé selon la revendication 8 ou la revendication 9, comprenant en outre :

- régler un gain (307) d'un amplificateur (73) du transformateur d'impédance (70) en fonction d'au moins une de la pluralité de valeurs d'étalonnage.

11. Procédé selon l'une quelconque des revendications 7 à 10, comprenant en outre :

- relier (308) la sortie de signal de test (61) et l'entrée de signal de référence (64) par l'intermédiaire de lignes de mesure (81, 82) à une première borne (15) du transformateur de tension (10, 20) et relier (308) l'entrée de transformateur d'impédance (71) par l'intermédiaire d'une ligne de mesure (83) à une deuxième borne (17) du transformateur de tension (10, 20),
- émettre (309) une pluralité de signaux de test par l'intermédiaire de la sortie de signal de test (61) à des fréquences différentes, et
- acquérir (310) une pluralité de valeurs de mesure à l'entrée de signal de référence (64) et à l'entrée de signal de réponse (67) par l'intermédiaire du transformateur d'impédance (70) et l'entrée de transformateur d'impédance (71), chaque valeur de mesure de la pluralité de valeurs de mesure étant associée à un signal de test correspondant de la pluralité de signaux de test.

12. Procédé selon la revendication 11, dans lequel chaque valeur de mesure de la pluralité de valeurs de mesure comprend au moins l'une des valeurs suivantes :

une amplitude d'un signal de tension à l'entrée de signal de référence (64),
un rapport entre l'amplitude du signal de tension à l'entrée de signal de référence (64) et une amplitude d'un signal de tension à l'entrée de signal de réponse (67), et
une différence de phase entre le signal de tension à l'entrée de signal de référence (64) et le signal de tension à l'entrée de signal de réponse (67).

13. Procédé selon la revendication 11 ou la revendication 12, comprenant en outre :

- corriger (311) une valeur de mesure de la pluralité de valeurs de mesure en utilisant une valeur d'étalonnage, la valeur de mesure et la valeur d'étalonnage étant associées à un signal de test respectif ayant la même fréquence.

14. Procédé selon l'une quelconque des revendications 11 à 13, comprenant en outre :

- déterminer (312) une erreur de rapport de tension et/ou un déphasage aux différentes fréquences sur la base de la pluralité de valeurs de mesure, et
- afficher (313) l'erreur de rapport de tension et/ou le déphasage aux différentes fréquences sur un dispositif d'affichage couplé à l'analyseur de réponse en fréquence (60).

15. Procédé selon l'une quelconque des revendications 11 à 14, comprenant en outre :

- déterminer (314) des valeurs caractéristiques du transformateur de tension (10, 20) sur la base de la pluralité de valeurs de mesure, les valeurs caractéristiques comprenant au moins une valeur choisie dans un groupe comprenant :

- une fréquence en cas d'une erreur de rapport de tension de 1%,

- une fréquence en cas d'une erreur de rapport de tension de 5%,
- une fréquence en cas d'une erreur de rapport de tension de 10%,
- une fréquence de résonance, et
- une erreur de rapport de tension à une fréquence de 50 Hz.

**Fig. 1**

**Fig. 2**

300

| Frequenzgang-Analysator und Impedanzwandler bereitstellen | 301 |

| Impedanzwandlerausgang mit Antwortsignaleingang koppeln | 302 |

| Eingangsimpedanz einstellen | 303 |

| Kalibrierkonfiguration einrichten | 304 |

| Prüfsignale ausgeben | 305 |

| Kalibrierwerte erfassen | 306 |

| Verstärkung einstellen | 307 |

| Prüfkonfiguration einrichten | 308 |

| Prüfsignale ausgeben | 309 |

| Messwerte erfassen | 310 |

| Messwerte korrigieren | 311 |

| Spannungsverhältnisfehler / Phasenversatz bestimmen | 312 |

| Spannungsverhältnisfehler / Phasenversatz anzeigen | 313 |

| Charakteristische Werte bestimmen | 314 |

**Fig. 3**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102018200869 A1

- US 2015288277 A1

**In der Beschreibung aufgeführte Nicht-Patentliteratur**

- **D. GOPP**. Einflussgrößen bei der modellbasierten Prüfung von kapazitiven Spannungswandlern - Was sind die einflussreichsten Parameter der modell-basierten Prüfung von kapazitiven Spannungswand-lern und wie wirken sich diese auf den Übersetzungs- und Phasenfehler aus?. *Masterarbeit Fachhoch-schule Vorarlberg*, 01 August 2019